# EUROPÄISCHE PATENTANMELDUNG

(11) **EP 3 106 728 A1**
(43) Veröffentlichungstag der Anmeldung: **21.12.2016**
(21) Anmeldenummer: 15172315.2
(22) Anmeldetag: 16.06.2015
(51) Int. Cl.: F16K 51/02, F16K 3/314, F16K 27/04, H01J 37/18

(54) **VAKUUMVENTIL MIT LINEARER FÜHRUNGSEINHEIT UND VENTILSYSTEM MIT EBENSOLCHEM VENTIL UND ANTRIEB**

(71) Anmelder: VAT Holding AG, 9469 Haag (CH)
(72) Erfinder: WEISS, Wolfgang, A-6971 Hard (AT)
(74) Vertreter: Kaminski Harmann

(57) **Zusammenfassung**

Vakuumventileinheit (10) zum gasdichten Schliessen eines Bewegungspfades mittels einer Linearbewegung, mit einem Ventilgehäuse (11) mit einer Durchtrittsöffnung (13) für den Bewegungspfad, und mit einer die Durchtrittsöffnung (13) umschliessenden Ventilsitzfläche. Die Vakuumventileinheit (10) weist ferner ein Verschlusselement (12) auf, das linear entlang einer zu der Öffnung quer verlaufenden Verstellachse in einer Verschlusselementebene von einer geöffneten Position in eine geschlossene Position in eine Schliessrichtung und umgekehrt zurück in eine Öffnungsrichtung verschiebbar ist, und eine der Ventilsitzfläche entsprechende Form aufweisende Verschlusselementfläche aufweist. Die Flächennormalen der Dichtflächen verlaufen im Wesentlichen parallel zu der Verschlusselementebene und die Flächen sind derart ausgebildet, dass jeweilige Hauptabschnitte (14a,14b,15a,15b) in jeweils zumindest zwei Ebenen parallel zur Verschlusselementebene vorliegen. Die Vakuumventileinheit weist eine Linearführungseinheit (20) auf, mit einem Führungselement, einer Führungsaufnahme und einer Rückstellkomponente. Das Ventilgehäuse (11) ist mit dem Verschlusselement (12) mittels der Linerführungseinheit (20) derart beweglich verbunden, dass dadurch die lineare Verschiebbarkeit entlang der Verstellachse definiert bereitgestellt ist, und die Rückstellkomponente wirkt derart mit dem Führungselement und der Führungsaufnahme zusammen, dass das Führungselement und die Führungsaufnahme mit einer Rückstellkraft parallel zur Verstellachse beaufschlagt sind.

## Beschreibung

Die Erfindung betrifft ein Vakuumventil zum gasdichten Schliessen eines Pfads nach dem Oberbegriff des Anspruchs 1.

Allgemein sind Vakuumventile zum im Wesentlichen gasdichten Schliessen eines Fliesswegs, Strömungswegs oder Strahlengangs, der durch eine in einem Ventilgehäuse ausgeformte Öffnung führt, in unterschiedlichen Ausführungsformen aus dem Stand der Technik bekannt. Vakuumschieberventile kommen insbesondere im Bereich der IC- und Halbleiterfertigung aber beispielsweise auch im Bereich der Elektronenmikroskopie, die ebenfalls in einer geschützten Atmosphäre möglichst ohne das Vorhandensein verunreinigender Partikel stattfinden muss, zum Einsatz.

Beispielsweise durchlaufen in einer Fertigungsanlage für Halbleiter-Wafer oder Flüssigkristall-Substrate die hochsensiblen Halbleiter- oder Flüssigkristall-Elemente sequentiell mehrere Prozesskammern, in denen die innerhalb der Prozesskammer befindlichen Halbleiterelemente mittels jeweils einer Bearbeitungsvorrichtung bearbeitet werden. Sowohl während des Bearbeitungsprozesses innerhalb der Prozesskammer, als auch während des Transports von Prozesskammer zu Prozesskammer müssen sich die hochsensiblen Halbleiterelemente stets in geschützter Atmosphäre - insbesondere im Vakuum - befinden. Die Prozesskammern sind beispielsweise über Verbindungsgänge miteinander verbunden, wobei die Prozesskammern mittels Vakuumschieberventile zum Transfer der Teile von der einen zur nächsten Prozesskammer geöffnet und im Anschluss zur Durchführung des jeweiligen Fertigungsschritts gasdicht verschlossen werden können. Derartige Ventile werden aufgrund des beschriebenen Anwendungsgebiets auch als Vakuum-Transferventile und aufgrund ihres rechteckigen Öffnungsquerschnitts auch als Rechteckschieber bezeichnet.

Im Bereich der Elektronenmikroskopie stellt das Einbringen und Entfernen einer zu untersuchenden Probe in das Analysevolumen den kritischen Verfahrensschritt in Bezug auf die Aufrechterhaltung bzw. effiziente Erzeugung oder Wiederherstellung des zur Analyse erforderlichen Niederdruck- bzw. Vakuumzustands dar. Typischerweise wird die Probe auf einem speziellen Halter in den Probenraum eingebracht und das Volumen anschliessend gasdicht verschlossen. Dies kann z.B. mittels eines manuell betätigbaren Verschlussmechanismus oder automatisiert erfolgen. Nach Abschliessen des Probenraums wird dieser für die mikroskopierende Untersuchung evakuiert.

Nach Erreichen eines Soll-Vakuumzustands innerhalb des Probenraums kann sodann eine Verbindung zu der Elektronenstrahlquelle hergestellt werden. Der erzeugbare Elektronenstrahl wird z.B. durch einen Kanal geführt, an dessen Ende der Proberaum angrenzt. An dem Übergang zwischen Führungskanal und Probenraum ist ein Verschlussmechanismus vorgesehen, mittels dessen ein gasdichtes Abtrennen des Kanals vom Probenraum zur Be- und Entladung desselbigen ermöglicht ist. Durch ein Öffnen des Verschlusses wird die Verbindung der Volumina etabliert, so dass der Elektronenstrahl auf die Probe treffen und diese damit entsprechend vermessen werden kann.

Zur Entnahme der Probe aus dem Mikroskop wird der Verschluss wieder geschlossen, das Probenvolumen belüftet und der Probenraum nach Erreichen eines erforderlichen Drucks im Inneren geöffnet. So bleibt der Vakuumzustand um die Elektronenstrahlquelle erhalten, wobei eine Entnahme und ggf. Wiederbeladung des Probenraums ermöglicht ist. Für die Untersuchung einer nächsten Probe ist somit die Evakuierung lediglich noch für das Analysevolumen, nicht jedoch für die Elektronenstrahlkammer notwendig.

Eine mögliche Ausführung für einen solchen Verschluss ist beispielsweise aus der EP 2 728 226 B1 bekannt. Darin wird ein Ventil zum Verschluss einer Durchtrittsöffnung beschrieben, dessen Verschlussorgan im Rahmen zweier Teilbewegungen auf die Durchtrittsöffnung angedrückt wird und mittels einer Dichtung an dem Verschlussorgan das Verschliessen der Öffnung realisiert ist. Die erste Teilbewegung erfolgt (zum Verschliessen) derart, dass das Verschlussorgan in eine Lage gebracht wird, in welcher eine durch die Durchtrittsöffnung definierte Achse den Verschlusskörper schneidet - das Verschlussorgan liegt über der Durchtrittsöffnung. Die zweite Teilbewegung erfolgt im Anschluss entlang dieser Achse derart, dass der Verschlusskörper auf eine die Durchtrittsöffnung umgebende Dichtfläche angepresst wird.

Die Abdichtung kann z.B. entweder über eine auf der Verschlussseite des Verschlusstellers (Verschlusskörpers) angeordnete Dichtung, die auf den die Öffnung umlaufenden Ventilsitz gepresst wird, erfolgen, oder über einen Dichtungsring auf dem Ventilsitz, gegen den die Verschlussseite des Verschlusstellers gedrückt wird. Unterschiedliche Dichtvorrichtungen sind aus dem Stand der Technik bekannt, beispielsweise aus der US 6,629,682 B2 (Duelli). Die Dichtung insbesondere der Dichtungsring, kann in einer Nut gehalten und/oder aufvulkanisiert sein. Ein geeignetes Material für Dichtungsringe ist beispielsweise das unter dem Handelsnamen Viton® bekannte elastische Dichtungsmaterial.

Die Anforderungen an die bei Vakuumventilen zum Einsatz kommenden Dichtungen sind typischerweise sehr hoch. Einerseits muss im geschlossenen Zustand des Ventils die Dichtigkeit des Ventils gewährleistet sein. Dies ist vor allem aufgrund der im Vakuumbereich hohen Differenzdrücke und der somit auftretenden grossen Kräfte, die auf den Ventilverschluss wirken, eine grosse Herausforderung. Da die zum Einsatz kommenden Dichtungen bei übermässig hohen Verpressungen einem überdurchschnittlichen hohen Verschleiss unterliegen oder zerstört werden, muss der Aufbau des Ventils derart sein, dass die Differenzdruckkräfte nicht oder nur begrenzt auf die Dichtungen wirken können. Die Verpressung der Dichtung sollte entlang ihres Verlaufs möglichst gleichmässig erfolgen, was eine gleichmässige Anpresskraft des Ventiltellers auf den Ventilsitz im gesamten Berührungsbereich erfordert. Vor allem sind Querbelastungen und Längsbelastungen auf die Dichtung möglichst gering zu halten. Bei Querbelastungen quer zu der Längsrichtung der Dichtung besteht bei O-Ring-Dichtungen die Gefahr, dass sie aus ihrer Halterung, insbesondere der Nut, in welcher sie fixiert sind, gerissen werden. Auch aufvulkanisierte Dichtungen dürfen nur sehr begrenzten Querkräften ausgesetzt werden. Ein übermässig hoher Verschleiss der Dichtung stellt einen Unsicherheitsfaktor für die Prozesssicherheit dar und erfordert einen regelmässigen Austausch der Dichtung, was wiederum zu erhöhten Stillstandszeiten führt.

Die Antriebstechnologie für eine oben beschriebene Ventilausführung (Pendelventil) könnte alternativ - wie ebenfalls aus dem Stand der Technik bekannt - als Schieberventilausführung, auch Ventilschieber oder Rechteckschieber genannt, gestaltet sein, wobei auch hier das Schliessen und Öffnen meistens in zwei Schritten erfolgt.

In einem ersten Schritt wird ein Ventilverschlusselement, insbesondere ein Verschlussteller oder ein Verschlusselement, im Falle eines Schieberventils, wie beispielsweise aus der US 6,416,037 (Geiser) oder der US 6,056,266 (Blecha) bekannt, insbesondere des L-Typs, linear über eine Öffnung im Wesentlichen parallel zum Ventilsitz verschoben oder im Falle eines Pendelventils, wie beispielsweise auch aus der US 6,089,537 (Olmsted) bekannt, um eine Schwenkachse über die Öffnung geschwenkt, ohne dass hierbei eine Berührung zwischen dem Verschlussteller und dem Ventilsitz des Ventilgehäuses stattfindet. In einem zweiten Schritt wird der Verschlussteller mit dessen Verschlussseite auf den Ventilsitz des Ventilgehäuses gedrückt, so dass die Öffnung gasdicht verschlossen wird.

Die beschriebene zweistufige Bewegung, bei welcher das Verschlussglied zuerst quer über die Öffnung geschoben wird, ohne dass es zu einer Berührung der Dichtung mit dem Ventilsitz kommt, und das Verschlussglied im Anschluss im Wesentlichen senkrecht auf den Ventilsitz gedrückt wird, hat neben der Möglichkeit einer präzisen Regelung des Durchflusses vor allem den Vorteil, dass die Dichtung nahezu ausschliesslich senkrecht verpresst wird, ohne dass es zu einer Quer- oder Längsbelastung der Dichtung kommt. Der Antrieb weist jedoch einen verhältnismässig komplexen Aufbau auf, der insbesondere entweder von einem einzigen Antrieb, der eine L-förmige Bewegung des Verschlussglieds ermöglicht, oder von einer Mehrzahl an Antrieben, beispielsweise zwei Linearantrieben oder einem Linear- und einem Spreizantrieb, gebildet wird. Spreizantriebe, welche meist unmittelbar hinter dem Verschlussteller angeordnet sind und diesen relativ zu dem Schaft, auf welchem sie sich befinden, in senkrechter Richtung auf den Ventilsitz verstellen, weisen eine Vielzahl an mechanischen Teilen, welche zueinander Relativbewegungen ausführen, im Ventilinneren auf.

Das Problem des komplexen Antriebsaufbaus für die zweistufige Bewegung kann mittels eines Schieberventils gelöst werden, bei welchen der Schliess- und Dichtvorgang zwar über eine einzige lineare Bewegung erfolgt, jedoch die Dichtgeometrie derart ist, dass eine Querbeanspruchung der Dichtung gänzlich vermieden wird. Ein solches Ventil ist beispielsweise das unter der Produktbezeichnung "MONOVAT Reihe 02 und 03" bekannte und als Rechteckinsertventil ausgestaltete Transferventil der Firma VAT Vakuumventile AG in Haag, Schweiz. Der Aufbau und die Funktionsweise eines solchen Ventils werden beispielsweise in der US 4,809,950 (Geiser) und der US 4,881,717 (Geiser) beschrieben.

Das dort beschriebene Ventil besitzt an seinem Gehäuse eine Dichtfläche, die, in Richtung der Achse der Ventildurchgangsöffnung gesehen, hintereinander liegende Abschnitte besitzt, die in seitlich nach aussen verlaufende, ebene Dichtflächenabschnitte über stetig verlaufende Krümmungen übergehen, wobei die gedachten Erzeugenden dieser einteiligen, aber mehrere Abschnitte aufweisenden Dichtfläche parallel zur Achse der Ventildurchgangsöffnung liegen. Die Dichtfläche ist bearbeitet. Das Verschlusselement besitzt eine dazu korrespondierende Auflagefläche für die umfangsgeschlossene Dichtung.

Für den Einsatz in einem Elektronenmikroskop ist ausserdem erforderlich, dass zwischen dem Antrieb des Ventils und dem Ventilverschluss zumindest in einer Offenstellung des Ventils, also für den Durchtritt des Elektronenstrahls durch die Durchtrittsöffnung, kein elektrisch leitfähiger Kontakt besteht. Somit muss beispielsweise ein elektrisch isolierendes Trennstück, z.B. aus Keramik gefertigt, entlang der Führung des Verschlusskörpers oder direkt an diesem vorgesehen werden. Neben dem dadurch wiederum deutlich erhöhten konstruktiven Aufwand sind die damit verbundenen ebenso erhöhten Kosten für das Ventil sehr nachteilig.

Ferner geht mit der Erhöhung der Komplexität des Ventilaufbaus gleichzeitig eine Abnahme der Flexibilität hinsichtlich der Integration eines solchen Ventils in ein bestimmungsgemässes Gerät, z.B. Elektronenmikroskop, einher. Mit zunehmender Komplexität leidet somit die bestimmungsgemässe Verwendungsfähigkeit des Ventils.

Es ist daher Aufgabe der Erfindung, ein Vakuumventil bereitzustellen, welches zum einen einen konstruktiv verbesserten, insbesondere wenig komplexeren, Aufbau bietet, insbesondre bei zumindest gleich bleibender Robustheit.

Eine weitere Aufgabe der Erfindung ist es, für den Einsatz in einem Elektronenmikroskop (oder einem anderen Gerät mit ähnlichen Anforderungen hinsichtlich elektrischer Isolation) eine elektrische Isolation des Antriebs von einem Ventilteller oder -sitz bereitzustellen.

Es ist ausserdem Aufgabe der Erfindung, ein verbessertes und flexibler einsetzbares Ventil bereitzustellen.

Diese Aufgaben werden durch die Verwirklichung der kennzeichnenden Merkmale der unabhängigen Ansprüche gelöst. Merkmale, die die Erfindung in alternativer oder vorteilhafter Weise weiterbilden, sind den abhängigen Patentansprüchen zu entnehmen.

Die Erfindung betrifft ein Vakuumventil mit einem Ventilsitz oder Ventilgehäuse und einem Verschlussteil zum Verschliessen einer Öffnung des Ventils. Zudem verfügt das Ventil über eine Führung, die eine definierte, begrenzte relative Bewegung der beiden Komponenten zueinander garantiert. Diese Relativbewegung ist eine lineare Bewegung insbesondere rechtwinklig zu einer durch die Öffnung definierten Achse. Zudem ist ein Rückstellelement, z.B. eine Federung, vorgesehen, das eine definierte Stellung der beiden Ventilteile bei Abwesenheit äusserer Kräfte bewirkt. Das Ventil liegt also normal in einem geöffneten oder geschlossenen Zustand vor. Durch Aufbringen einer äusseren Kraft ist der Verschluss in die jeweils andere Position linear verschiebbar. Für die Bereitstellung einer ausreichenden Dichtwirkung bei dieser Linearverschiebung weisen sowohl Ventilsitz als auch Verschluss eine entsprechende Dichtungsgeometrie auf, wie eine solche z.B. von einem Monoventil des Typs "MONOVAT Reihe 02 und 03" der Firma VAT Vakuumventile AG in Haag, Schweiz bekannt ist.

Die Erfindung betrifft also eine Vakuumventileinheit zum gasdichten Schliessen eines Bewegungspfades mittels einer Linearbewegung. Der Bewegungspfad kann dabei z.B. ein Fliess- oder Strömungsweg in Kanalform für ein Fluid, ein freier optischer Strahlengang oder ein Ausbreitungspfad für eine Materiewelle, beispielsweise einen Elektronenstrahl, sein.

Die Vakuumventileinheit weist ein Ventilgehäuse mit einer Durchtrittsöffnung für den Bewegungspfad, wobei die Durchtrittsöffnung eine geometrische Öffnungsachse in Durchtrittsrichtung definiert, und eine die Durchtrittsöffnung umschliessende, zumindest teilweise gekrümmte Ventilsitzfläche auf. Das Ventilgehäuse kann somit im Verlauf des Bewegungspfads vorgesehen sein, wobei die Durchtrittsöffnung mit dem Pfad korrespondiert, um eine Unterbrechung des Pfades durch Schliessen der Öffnung bei Bedarf zu schaffen.

Zudem verfügt die Vakuumventileinheit über ein Verschlusselement, das linear entlang einer zu der Öffnungsachse quer verlaufenden, geometrischen Verstellachse in einer Verschlusselementebene von einer die Durchtrittsöffnung freigebenden, geöffneten Position in eine über die Durchtrittsöffnung linear geschobene, geschlossene Position in eine Schliessrichtung und umgekehrt zurück in eine Öffnungsrichtung verschiebbar ist. Das Verschlusselement weist eine mit der Ventilsitzfläche korrespondierende, eine der Ventilsitzfläche entsprechende Form aufweisende Verschlusselementfläche auf.

Die Flächennormalen der zumindest teilweise gekrümmten Ventilsitzfläche und der (entsprechend ebenfalls gekrümmten) Verschlusselementfläche verlaufen im Wesentlichen parallel zu der Verschlusselementebene. Des Weiteren sind die Ventilsitzfläche und die Verschlusselementfläche derart ausgebildet, dass jeweilige Hauptabschnitte dieser Flächen in jeweils zumindest zwei unterschiedlichen Ebenen parallel zur Verschlusselementebene vorliegen.

Die beiden Flächen weisen demnach derartige Formen auf, dass in der Schliessposition eine Abdichtung der Öffnung durch die passenden Formen und Dimensionen dieser Dichtflächen erreicht wird. Insbesondere ist zudem ein Dichtmaterial entweder seitens des Verschlusselements (auf der Verschlusselementfläche) oder des Ventilgehäuses (auf der Ventilsitzfläche) vorgesehen (oder auch beidseitig), wobei dieses Material in geschlossener Position an das jeweilige Gegenstück angedrückt wird und somit eine entsprechende Dichtwirkung bereitstellt.

Erfindungsgemäss weist die Vakuumventileinheit eine Linearführungseinheit auf mit einem Führungselement, einer Führungsaufnahme für das Führungselement und einer Rückstellkomponente. Das Ventilgehäuse ist dabei mit dem Verschlusselement mittels der Linerführungseinheit derart beweglich verbunden, dass dadurch die lineare Verschiebbarkeit entlang der Verstellachse definiert (z.B. in strukturell vorgegebenen Grenzen) bereitgestellt ist. Die Rückstellkomponente ist derart mit dem Führungselement und der Führungsaufnahme angeordnet und wirkt mit diesen derart zusammen, dass das Führungselement und die Führungsaufnahme mit einer Rückstellkraft parallel zur Verstellachse beaufschlagt sind.

Mittels der so erzeugten Rückstellkraft wird eine Normal-Ventilstellung in der geöffneten oder der geschlossenen Position - in Abhängigkeit der Anordnung der Komponenten der Linearführungseinheit - bereitgestellt. Die relative Beweglichkeit des Verschlusselements zum Ventilgehäuse ist insbesondere durch die strukturelle Ausgestaltung der Führungsaufnahme und des Führungselements definiert begrenzt, so dass dadurch die geöffnete bzw. geschlossene Position eindeutig bestimmt ist.

Das Führungselement kann beispielsweise als zylindrisch gestalteter Bolzen, Kolben oder Stab ausgeführt sein. Die Führungsaufnahme kann z.B. als hohlzylindrische Hülse oder Ausnehmung ausgeführt sein.

Ein Anwendungsgebiet für ein derartiges Vakuumventil ist insbesondere die Elektronenmikroskopie. Dabei kann der Bewegungspfad einen Ausbreitungsweg eines Elektronenstrahls eines Elektronenmikroskops verkörpern und die Vakuumventileinheit zum gasdichten Trennen des Bewegungspfads zu einem Probenraum ausgebildet sein.

Gemäss einer Ausführungsform der Vakuumventileinheit ist das Führungselement starr mit dem Verschlusselement verbunden, bildet insbesondere einen Teil des Verschlusselements. Das Führungselement kann hierbei insbesondere einstückig mit dem Verschlusselement ausgeführt sein.

Generell unabhängig von der Ausgestaltung oder Anordnung des Führungselements ist die Anordnung der Führungsaufnahme. Die Führungsaufnahme kann seitens des Ventilgehäuses starr mit diesem Gehäuse verbunden sein, insbesondere in das Ventilgehäuse integriert oder aussen an das Ventilgehäuse angebunden sein.

Die Linearführung kann also als externe Führung implementiert sein, wobei sowohl Führungselement als auch Führungsaufnahme äusserlich mit den jeweiligen Komponenten verbunden sind oder zumindest teilweise integriert in zumindest eines der beiden Bauteile vorliegen.

Es versteht sich, dass die Anordnung von Führungselement und Führungsaufnahme erfindungsgemäss entsprechend vertauscht sein kann, d.h. das Führungselement ist seitens des Ventilgehäuses und die Führungsaufnahme an dem Verschlusselement vorgesehen.

Mittels der Linearführungseinheit wird eine Beschränkung der jeweiligen Bewegungsfreiheitsgrade des Ventilgehäuses und des Verschlusselements relativ zueinander erzeugt, d.h. das Verschlusselement ist nicht in allen sechs Freiheitsgraden (drei translatorische und drei rotatorische Freiheitsgrade) relativ zum Ventilgehäuse frei bewegbar. Bevorzugt sind das Ventilgehäuse und das Verschlusselement mittels der Linerführungseinheit derart beweglich verbundnen sind, dass eine relative Beweglichkeit nur in einem Freiheitsgrad entlang der Verstellachse gegeben ist.

Zudem kann diese rein lineare Beweglichkeit insbesondere bezüglich der möglichen Bewegungsstrecke durch die konstruktive Ausgestaltung der Führungseinheit definiert beschränkt sein, im Speziellen derart, dass dadurch ein vollständiges Öffnen und Schliessen der Durchtrittsöffnung zumindest gewährleistet ist. Mit anderen Worten ist die Linerführungseinheit so ausgestaltet, dass eine entsprechend der Verschiebbarkeit des Verschlusselements aus der geschlossenen in die geöffnete Position begrenzte Verschiebungsstrecke für die lineare Verschiebbarkeit entlang der Verstellachse definiert ist.

Die Erfindung erstreckt sich auch hinsichtlich einer entsprechenden Ausführung zur Begrenzung der Verschiebungsstrecke auf die strukturelle Ausgestaltung der Linearführung. Gemäss einer Ausführungsform ist die Verschiebungsstrecke durch einen Vorsprung des Führungselements begrenzt, welcher mit einer strukturell vorgesehenen Begrenzung der Führungsaufnahme, insbesondere einem Ende der Führungsaufnahme oder einer Buchse, zusammenwirkt. Eine solche Buchse oder ein alternatives Begrenzungselement kann beispielsweise verspannt oder verklebt in die Führungsaufnahme eingebracht sein und so ein Rückhalteelement für das Führungselement bilden.

Gemäss einer bestimmten Ausführungsform wirkt die Rückstellkraft derart in die Öffnungsrichtung, dass das Verschlusselement in einem Normalzustand in einer der geöffneten Position entsprechenden Normalposition vorliegt, insbesondere wobei die Rückstellkomponente eine Feder oder Zugfeder ist. Z.B. ist eine Feder hierfür zwischen einem äusseren Ende der Führungsaufnahme und dem Führungselement (bzw. einem Vorsprung an diesem Element) vorgesehen und vorgespannt. So wirkt in jeder Relativstellung der Führungskomponenten eine gewünschte Rückstellkraft in Öffnungsrichtung.

Es versteht sich, dass die Rückstellkomponente alternativ zu einer Feder zumindest im Rahmen des dem Fachmann Bekannten ausgestaltet sein kann. Insbesondere kann ein elastisches Element (z.B. Polymer, Gummi) oder auch eine Druckfederung vorgesehen werden.

Gegensätzlich und alternativ zu obiger Ausgestaltung kann die Rückstellkraft auch derart in die Schliessrichtung wirkt, dass das Verschlusselement in einem Normalzustand in einer der geschlossenen Position entsprechenden Normalposition vorliegt, insbesondere wobei die Rückstellkomponente eine Feder oder Zugfeder ist. Eine entsprechende Realisierung ist durch entsprechende, alternative Anordnung der Komponenten möglich (siehe Figuren).

Für den Einsatz der Vakuumventileinheit in Niederdruckbereichen, insbesondere für hinsichtlich hochgenauer Messgeräte, kann die Linearführungseinheit, insbesondere die Führungsaufnahme, gemäss einer bestimmten Ausführungsform partikeldicht ausgebildet ist, insbesondere wobei das Führungselement aus abriebsarmem, insbesondere abriebsfreiem, Material gefertigt ist. Durch eine solche konstruktive Massnahme kann das Ventil auch in verschmutzungskritischen Fertigungs- oder Analysebereichen eingesetzt werden.

Für eine weiter optimierte Gewährleistung der Stellung des Ventils im geschlossenen bzw. geöffneten Zustand kann die Vakuumventileinheit eine (nach Bedarf) lösbare (und auch feststellbare) Arretiervorrichtung aufweisen, welche ein Halten des Verschlusselements in der geöffneten und/oder geschlossenen Position und ein jeweiliges Lösen des Haltens nach Bedarf bereitstellt.

Bezüglich der Ausgestaltung der jeweiligen Dichtflächen der beiden Ventilkomponenten (Ventilgehäuse und Verschlusselement) ist kann erfindungsgemäss insbesondere eine Ausformung nach einem oben referenzierten Monoventil bereitgestellt sein. Eine solche Ausgestaltung ist im Folgenden in anderen Worten nochmals beschrieben:
- die Ventilsitzfläche weist unterschiedlich geformte, jeweils zu der Verstellachse nichtparallele Abschnitte auf,
- die Flächennormalen dieser Abschnitte der Ventilsitzfläche weisen zu der Verstellachse jeweils parallele Richtungskomponenten auf (und somit die Ventilsitzfläche senkrecht oder schräg in die Öffnungsrichtung weist),
- ein erster Hauptabschnitt der Ventilsitzfläche verläuft im Wesentlichen entlang einer geometrischen ersten Hauptebene,
- ein zweiter Hauptabschnitt der Ventilsitzfläche verläuft im Wesentlichen entlang einer geometrischen zweiten Hauptebene,
- die erste Hauptebene und die zweite Hauptebene sind zueinander beabstandet und verlaufen parallel zu der Verschlusselementebene,
- der erste Hauptabschnitt und der gegenüberliegende zweite Hauptabschnitt weisen zueinander einen geometrischen Versatz quer zu der Verstellachse auf,
- zwischen den beiden gegenüberliegenden Hauptabschnitten ist die Durchtrittsöffnung angeordnet,
- ein seitlicher erster U-förmiger Seitenabschnitt der Ventilsitzfläche verbindet den ersten Hauptabschnitt und den zweite Hauptabschnitt auf der einen Seite der Ventilsitzfläche,
- ein seitlicher zweiter U-förmiger Seitenabschnitt der Ventilsitzfläche verbindet den ersten Hauptabschnitt und den zweiten Hauptabschnitt auf der anderen Seite der Ventilsitzfläche,
- der erste U-förmige Seitenabschnitt und der zweite U-förmige Seitenabschnitt weisen jeweils einen dem ersten Hauptabschnitt zugeordneten ersten Schenkel, einen dem zweiten Hauptabschnitt zugeordneten zweiten Schenkel und eine Basis, die insbesondere als Bogen ausgebildet ist, auf,
- die beiden ersten Schenkel verlaufen jeweils im Wesentlichen entlang zu der Verstellachse parallelen ersten Schenkelebenen,
- der erste Schenkel und der zweite Schenkel weisen zueinander einen geometrischen Versatz quer zu der Verstellachse auf,
- die jeweilige Basis verbindet jeweils den ersten Schenkel und den zweiten Schenkel und überbrückt den geometrischen Versatz quer zu der Verstellachse, und
- die Verschlusselementfläche steht in der geschlossenen Position in einem auf die Ventilsitzfläche in die Schliessrichtung drückenden - vermittels eines Dichtmaterials - dichtenden Kontakt mit der Ventilsitzfläche. wodurch die Durchtrittsöffnung gasdicht verschlossen ist.

In einer Erweiterung der Vakuumventileinheit ist diese mit einer passenden (Linear-) Antriebseinheit vorgesehen, um ein gewünschtes Bewegen des Verschlusselements (gesteuert) zu ermöglichen.

Die Erfindung betrifft also auch ein Vakuumventilsystem aus einer Vakuumventileinheit wie oben beschrieben und einer erwähnten Antriebseinheit. Die Antriebseinheit ist hierbei bevorzugt als lineare Antriebseinheit, d.h. eine Kraft und Bewegung einer Antriebskomponente ein eine lineare Richtung (und Gegenrichtung) bereitstellend, ausgebildet. Die Vakuumventileinheit und die Antriebseinheit sind derart angeordnet und wirken derart zusammen, dass das Verschlusselement mittels der Antriebseinheit entlang der Verstellachse verschiebbar ist.

Zum Verschieben des Verschlusselements ist somit eine der Rückstellkraft entgegenwirkende Antriebskraft mittels der Antriebseinheit bereitstellbar und die Antriebseinheit weist ein entlang einer Bewegungsachse (der Antriebseinheit) zumindest im Wesentlichen parallel zur Verstellachse bewegbares Kontaktelement zur Kontaktierung des Verschlusselements für das Verschieben auf. Ferner ist die Antriebseinheit derart ausgebildet und angeordnet, dass das Kontaktelement entlang der Bewegungsachse sowohl in Kontakt mit dem Verschlusselement als auch kontaktlos mit dem Verschlusselement bewegbar und positionierbar ist. Bei Vorliegen von Kontaktlosigkeit ist die Antriebseinheit sodann elektrisch und mechanisch von der Vakuumventileinheit getrennt.

Zur Schaffung der möglichen Bewegung des Kontaktelements in Kontakt sowie kontaktlos ist eine Bewegbarkeit dieses Elements insbesondere so vorgesehen, dass über einen ersten Teil der Bewegungsstrecke ein solcher Kontakt (aufgrund der gegenseitigen Anordnung von Ventil und Antrieb) vorliegt und in einen benachbarten zweiten Teil der Bewegungsstrecke keine Kontaktierung des Ventils (des Verschlusselements) ermöglicht ist - dies aufgrund der ebenfalls begrenzten Beweglichkeit des Verschlusselements entlang der linearen Verstellachse.

Im Besonderen stellt die Antriebseinheit eine Bewegungsstrecke für das Kontaktelement entlang der Bewegungsachse bereit, die grösser ist als die der Verschiebung des Verschlusselements aus der geschlossenen in die geöffnete Position entsprechenden Verschiebungsstrecke. So kann das Verschlusselement über die gesamte durch die Linearführungseinheit vorgesehene Strecke bewegt werden und zudem ein Ablösen des Kontaktelements durch einen grösseren Verschiebungsweg des Kontaktelements bereitgestellt werden.

Gemäss einer bestimmten Ausführungsform des Ventilsystems - wie ein solches beispielsweise in einem Elektronenmikroskop einsetzbar ist - wirken die Vakuumventileinheit und die Antriebseinheit derart zusammenwirken, dass das Verschlusselements linear entlang der Verstellachse von der geschlossenen Position, in welcher die gegen die Rückstellkraft wirkende Kraft mittels der Antriebseinheit bei Kontakt des Kontaktelements mit dem Verschlusselement bereitgestellt ist, in die geöffnete Position in geeigneter Weise verschiebbar ist. Das Verschiebe in die geöffnete Position erfolgt hierbei durch ein Bewegen des Kontaktelements entlang der Bewegungsachse zumindest im Wesentlichen in Öffnungsrichtung und ein gleichzeitiges Wirken der durch die Rückstellkomponente der Linearführungseinheit bereitgestellten Rückstellkraft. Das Verschlusselement folgt hier der Bewegung des Kontaktelements veranlasst durch die wirkende Rückstellkraft. Ferner ist im Weiteren eine elektrische Isolation der Antriebseinheit von der Vakuumventileinheit durch ein Weiterbewegen des Kontaktelements entlang der Bewegungsachse zumindest im Wesentlichen in Öffnungsrichtung nach Erreichen der geöffneten Position herstellbar. Dadurch (durch das Bewegen des Kontaktelements über eine der geöffneten Position entsprechende Stellung des Kontaktelements hinaus) wird ein physischer Kontakt des Kontaktelements mit dem Verschlusselement unterbrochen.

Die erfindungsgemässe Ventilvorrichtung und das erfindungsgemässe Ventilsystem werden nachfolgend anhand von in den Zeichnungen schematisch dargestellten konkreten Ausführungsbeispielen rein beispielhaft näher beschrieben, wobei auch auf weitere Vorteile der Erfindung eingegangen wird. Im Einzelnen zeigen:
- Fig. 1: eine erfindungsgemässe Vakuumventileinheit mit einem Ventilgehäuse und einem Verschlusselement in geöffneter Position in Draufsicht;
- Fig. 2: die Vakuumventileinheit gemäss Fig. 1 in einer Seitenansicht;
- Fig. 3: eine erfindungsgemässe Vakuumventileinheit gemäss Fig. 1 mit linearer Führungseinheit im Querschnitt;
- Fig. 4a-c: weitere Ausführungsformen für erfindungsgemässe Vakuumventileinheiten mit jeweils einem Ventilsitz und einem Verschlusselement; und
- Fig. 5: eine erfindungsgemässe Anordnung einer Ventileinheit zusammen mit einer Antriebseinheit in einem Elektronenmikroskop zum Schliessen und Öffnen eines Bewegungspfades des Elektronenstrahls.

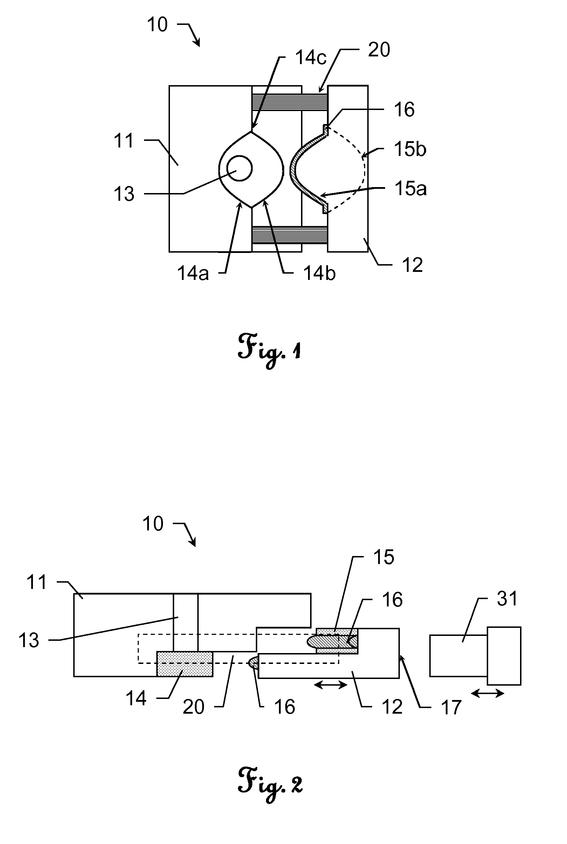

Fig. 1 zeigt eine erfindungsgemässe Vakuumventileinheit 10 mit einem Ventilgehäuse 11 und einem Verschlusselement 12 in geöffneter Position in Draufsicht. Das Ventilgehäuse 11 weist eine Durchtrittsöffnung 13 für einen Bewegungspfad (Fliessweg bzw. Führungskanal) für Materie und/oder Strahlung, insbesondere Fluide, auf. Das Vakuumventil 10 ist ausgebildet zum gasdichten Verschliessen und Öffnen der Durchtrittsöffnung 13 unter Vakuumbedingungen, wobei zumindest auf einer Seite der Durchtrittsöffnung 13 ein Vakuumvolumen vorliegen kann und diese bei Abschluss durch das Ventil stabil erhalten bleibt.

Das Ventilgehäuse 11 verfügt zur Herstellung der Abdichtung über eine gekrümmte Ventilsitzfläche bestehend aus den bezeichneten Abschnitten 14a-14c wie eine derartige oder ähnliche z.B. bekannt ist durch ein Ventil der Bezeichnung "MONOVAT Reihe 02 und 03" Transferventil der Firma VAT Vakuumventile AG in Haag, Schweiz. Die Ventilfläche umschliesst dabei die Durchtrittsöffnung 13 durch eine Erstreckung der Ventilsitzfläche im Wesentlichen in zwei bezüglich der Durchtrittsrichtung hintereinander liegenden Ebenen (der Abschnitt 14b liegt in der dargestellten Betrachtung hinter Abschnitt 14a), wobei die beiden Hauptabschnitte 14a,14b in den Ebenen durch zwei beiderseitige Schenkel 14c (nur einer bezeichnet) verbunden sind.

Das Verschlusselement 12 weist eine bezüglich der Form und räumlichen Ausdehnung zur Ventilsitzfläche des Gehäuses 11 korrespondierende Verschlusselementfläche auf, deren erster Abschnitt 15a entsprechend (im Wesentlichen als Negativ) des Hauptabschnitts 14a und deren zweiter Abschnitt 15b entsprechend des Hauptabschnitts 14b ausgeformt ist.

Auf der Verschlusselementfläche ist ein Dichtmaterial 16 definierter Höhe und Breite aufgebracht. Bei Schliessen des Ventils 10 wird das Dichtmaterial 16 zwischen der Ventilsitzfläche und der Verschlusselementfläche ge- bzw. verpresst, wodurch die gewünschte Dichtwirkung erreicht wird.

Mit anderen Worten besitzt ein so genannter Ventilschieber 10 wie dargestellt ein Schiebergehäuse 11 (Ventilgehäuse) und eine Schieberdurchgangsöffnung 13 (Durchtrittsöffnung), die mit einem in seiner Ebene verschiebbaren Verschlusselement 12 verschliessbar ist. Im Bereich der Schieberdurchgangsöffnung 13 ist eine Dichtfläche vorgesehen, an der in der Schliessstellung des Verschlusselementes 12 eine an diesem angeordnete, umfangsgeschlossene Dichtung 16 anliegt, wobei die Normalen der Dichtfläche im Wesentlichen orthogonal zu einer Achse der Schieberdurchgangsöffnung 13 (geometrische Öffnungsachse in Durchtrittsrichtung) liegen. Die umfangsgeschlossene, einstückige Dichtung 16 weist Abschnitte unterschiedlicher Längen und/oder Formen auf, die in verschiedenen Ebenen liegen, wobei zwei Hauptabschnitte 15a,15b der umfangsgeschlossenen Dichtung 16 bzw. der Verschlusselementfläche in Ebenen liegen, welche zur Achse der Schieberdurchgangsöffnung 13 im Wesentlichen rechtwinklig stehen und voneinander distanziert sind. Die beiden Hauptabschnitte 15a,15b der Dichtung 16 bzw. der Verschlusselementfläche sind durch Seitenabschnitte (Schenkel) verbunden. Das Verschlusselement 12 besitzt zum Verlauf der Dichtfläche (Ventilsitzfläche) des Gehäuses 11 eine korrespondierend verlaufende, die umfangsgeschlossene Dichtung 16 tragende Fläche. Die Seitenabschnitte der umfangsgeschlossenen Dichtung verlaufen z.B. U-förmig. Jeweils die Schenkel dieser U-förmig verlaufenden Seitenabschnitte liegen in einer Ebene. Die in Achsrichtung der Schieberdurchgangsöffnung 13 gesehen hintereinander liegenden Abschnitte 14a,14b bzw. 15a,15b der Dichtfläche gehen in seitlich nach aussen verlaufende ebene Dichtflächenabschnitte über. Diese ebenen Dichtflächenabschnitte liegen in zueinander und zur Achse der Schieberdurchgangsöffnung 13 parallel liegenden Ebenen.

Die erfindungsgemässe Vakuumventileinheit 10 verfügt über eine Linearführungseinheit 20. Die Linearführung 20 weist zumindest ein Führungselement und eine Führungsaufnahme für das Führungselement auf. Aufgrund der gewählten Darstellung ist hier lediglich jeweils ein Teil der vorgesehenen Führungselemente zu sehen. Diese sind jeweils fix mit dem Verschlusselement 12 verbunden und in einer Führungsaufnahme seitens der Ventilgehäuses 11 gefasst. Dadurch ist eine stabile Verbindung von Verschlusselement 12 und Ventilgehäuses 11 gegeben, wobei eine relative Beweglichkeit der beiden Komponenten orthogonal zur Öffnungsachse der Durchtrittsöffnung 13 und in Richtung der Erstreckung der Führungselemente bereitgestellt ist. Somit ist ein Verschliessen der Durchtrittsöffnung 13 mittels allein einer relativen Linearbewegung ermöglicht.

Fig. 2 zeigt die Ventileinheit 10 gemäss Fig. 1 in einer Seitenansicht. Verdeutlicht sind hierbei die Position und der Verlauf der Ventilsitzfläche 14 bezüglich der Durchtrittsöffnung 13 des Ventils 10. Des Weiteren ist das korrespondierende Gegenstück zur Ventilsitzfläche 14, die Verschlusselementfläche 15 mit dem darauf befindlichen Dichtmaterial 16 und dessen Verlauf und Erstreckung über mehrere Ebenen orthogonal zur Achse des Durchtrittskanals 13 ersichtlich.

Die Lage der Linearführungseinheit 20 relativ zu Ventilsitz 11 und Ventilverschluss 12 ist rein schematisch angedeutet.

Eine beispielhafte Ausgestaltung einer erfindungsgemässen Dichtungsgeometrie für die Ventileinheit 10 ist z.B. der US 4,809,950 (siehe auch oben) oder auch der EP 2 420 709 entnehmbar.

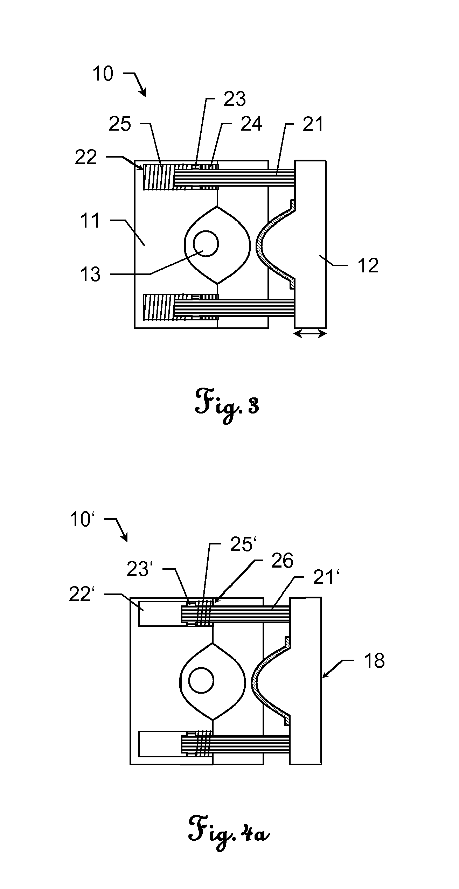

Fig. 2 zeigt ferner ein Kontaktelement 31 einer Antriebseinheit und eine für die Kontaktierung durch das Kontaktelement 31 vorgesehene Kontaktfläche 17 seitens der Verschlusseinheit 12. Zum Verschlissen des Ventils 10 kann somit das Kontaktelement 31 in Richtung des Ventilgehäuses 11 bewegt werden, wodurch zunächst ein Kontakt zum Verschlussteil 12 hergestellt wird und durch eine Fortführung der Bewegung ein lineares Verschieben des Verschlusselements 12 relativ zum Ventilgehäuse 11 stattfinden kann bis das Dichtmaterial 16 mit der Ventilsitzfläche in Kontakt steht und darauf angepresst wird. So ist ein Verschluss der Durchtrittsöffnung 13 bereitgestellt. Bei einer veranlassten Rückbewegung des Kontaktelements 31 folgt das Verschlussteil 12 dieser Bewegung aufgrund einer Rückstellkraft, die durch eine vorgesehen Rückstellkomponente in der Linearführungseinheit 20 (siehe Fig. 3) in entsprechende Richtung wirkt, bis wiederum die geöffnete Position erreicht ist. In der weiteren Rückbewegung des Kontaktelements 31 wird der Kontakt zu dem Verschlussteil 12 wieder gelöst, d.h. Kontaktelements 31 und Verschlussteil 12 liegen dann physisch getrennt vor.

Fig. 3 zeigt eine erfindungsgemässe Vakuumventileinheit 10 gemäss Fig. 1 im Querschnitt in einer Ebene durch die lineare Führungseinheit. Neben den bereits mit Fig. 1 beschriebenen Dichtungselementen ist hier die Linearführungseinheit des Ventils 10 im Detail dargestellt.

Das Führungselement 21 ist dabei fest mit dem Verschlussglied 12 verbunden. Das Ventilgehäuse 11 weist eine entsprechende Führungsaufnahme 22 auf, wobei diese Führungsaufnahme 22 hier als hohlzylindrische Ausnehmung in das Ventilgehäuse 11 integriert ist. Das Führungselement 21 wird mittels eines führungselementseitigen Vorsprungs 23 und einer in der Führungsaufnahme 22 befestigten (z.B. durch Verpressung, Spannung, Klebung, Lötung etc.) Buchse 24 in der Führungsaufnahme 22 beweglich gehalten. Die Buchse kann beispielsweise aus Kunststoff oder Metall, z.B. Messing, gefertigt sein. Eine Feder 25 dient als Rückstellkomponente und bewirkt eine Rückstellkraft auf das Führungselement 21 (bzw. den Vorsprung 23) orthogonal zur Öffnungsachse und entlang des Führungselements 21 derart, dass das Verschlusselement 12 in einer Normalstellung, d.h. bei Abwesenheit weiterer Stellkräfte, in geöffneter Position wie dargestellt vorliegt.

Die Vakuumventileinheit 10 kann mehrere solcher Führungselement/Führungsaufnahme Kombinationen zur linearen Führungen des Verschlusselements 12 relativ zum Ventilgehäuse 11 aufweisen (hier gezeigt derer zwei).

Durch eine derartige erfindungsgemässe Konstruktion und Ausgestaltung der Vakuumventileinheit 10 kann in der geöffneten Stellung eine vollständige Abkopplung einer Antriebskomponente (hier nicht gezeigt), welche ein Schliessen des Ventils 10 durch Kraftaufbringung entgegen der Rückstellkraft bewirken kann, erfolgen. Die Trennung der Antriebseinheit kann somit sowohl mechanisch als auch elektrisch umgesetzt werden, wodurch die Ventileinheit 10 optimal für Vakuumanwendungen mit dem Erfordernis einer elektrischen Abtrennbarkeit (Isolation) des Ventils 10 bzw. des mit dem Ventil versehenen Fliessweges (Bewegungspfades) Anwendung findet.

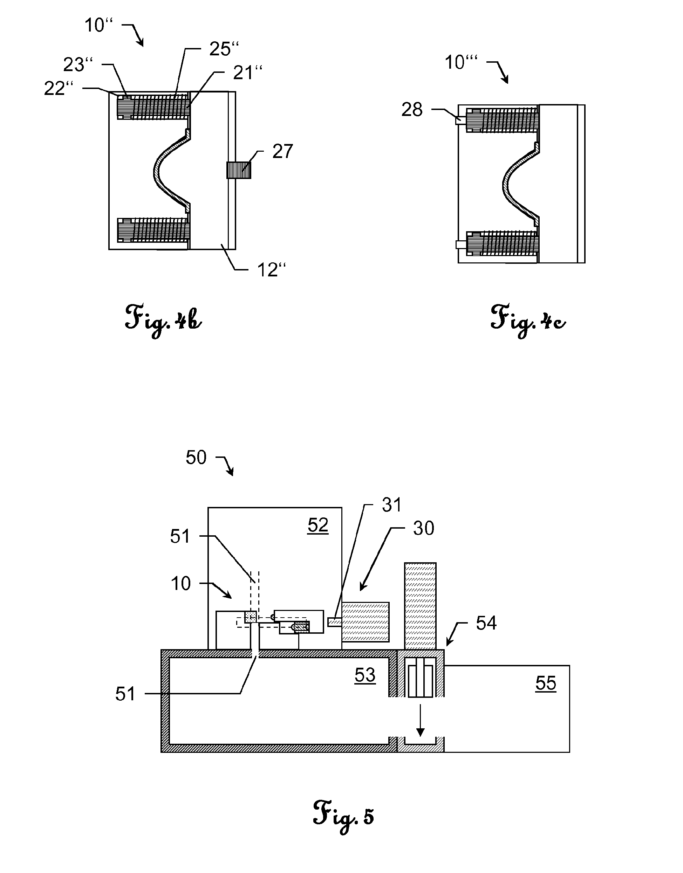

Insbesondere ist eine solche Ausführung für den Einsatz in einem Elektronenmikroskop zur gasdichten Abtrennung der Elektronenstrahlquelle während einem Ent- und Beladen des Probenraums besonderes gut geeignet (vgl. Fig. 5). Während dem Betrieb des Rastermikroskops kann ein Führungskanal (als Form des Bewegungspfades) für den Elektronenstrahl durch Öffnen des Ventils freigeben werden, wobei das Ventil ohne Kraftaufbringung von aussen und elektrisch isoliert in der geöffneten Position verbleibt.

Die Figuren 4a-4c zeigen weitere Ausführungsformen für erfindungsgemässe Vakuumventileinheiten 10'-10"', jeweils einen Ventilsitz (Ventilgehäuse) und ein Verschlusselement aufweisend. Allen drei Ausführungsformen ist zumindest die konstruktiv vorgesehne lineare Verschiebbarkeit des jeweiligen Verschlusselements zum jeweiligen Ventilsitz gemein, sodass ein gasdichtes Schliessen bzw. Öffnen der Durchtrittsöffnung mittels nur einer solchen Linearverschiebung des Verschlusselements herstellbar ist.

Fig. 4a zeigt eine erfindungsgemässe Ausführungsform mit einem verschlussseitigen Führungselement 21' in Form eines Bolzens, welches in einer Führungsaufnahme 22' gehalten und dadurch begrenzt linear in Schliess- und Öffnungsrichtung verschiebbar ist. Diese Führungseinheit verfügt zudem über eine Zugfeder 25', welche zum einen an einem Vorsprung 23' des Führungselements 21' und zum zweiten an einem Ende 26 der Führungsaufnahme 22' befestigt ist. Die Zugfeder 25' übt eine Rückstellkraft auf das Führungselement 21' relativ zur Führungsaufnahme 22' derart aus, dass das Ventil 10' in einer Ruhestellung, also ohne externe Kraftaufbringung, eine Offenposition (geöffnete Position) wie gezeigt einnimmt.

Zum Schlissen des Ventils 10' wird vorzugsweise eine steuerbare Antriebseinheit mit einem Kontaktelement vorgesehen. Das Kontaktelement wird hierzu mit der Endseite 18 des Verschlusselements kontaktiert und bewirkt eine Kraft in entgegengesetzter Richtung zur Zugkraft der Zugfeder 25', wodurch das Verschlusselement linear auf den Ventilsitz geschoben wird und dadurch ein Abdichten der Durchtrittsöffnung bewirkt.

Fig. 4b zeigt eine Ausführungsform mit einer in der Führungsaufnahme 22" vorliegenden Feder 25" , die auf einen Vorsprung des Führungselements 21" in Schliessrichtung drückt und so eine Normalstellung des Vakuumventils 10" in einer geschlossenen Position bewirkt. Die Federkraft ist hierbei so gewählt, dass ein dadurch bewirkter Druck zwischen Ventilgehäuse und Verschlusselement zu einer die Vakuumabdichtung bereitstellenden An- bzw. Verpressung des Dichtmaterials führt. Der Verschluss der Durchtrittsöffnung ist somit ohne Aufbringen einer zusätzlichen externen Kraft gewährleistet.

Zudem weist die Ventileinheit 10" eine Kupplung 27 auf, welche das lösbare Ankoppeln einer Antriebseinheit an das Verschlusselement 12" ermöglicht. Mittel einer so angekoppelten Antriebseinheit kann eine Zugkraft auf das Verschlusselement 12" (der Federkraft entgegengerichtet) ausgeübt und das Ventil entsprechend geöffnet werden. Die Kupplung kann beispielsweise als Öse, Haken oder Magnet ausgebildet sein. Ferner kann die Kupplung aus magnetischem Material zur Ankopplung eines antriebsseitigen Elektromagneten ausgeformt sein, z.B. als in das Verschlusselement integrierte metallische Kontaktplatte.

Fig. 4c zeigt eine weitere Ausführungsform, die sich von der Ausführungsform gemäss Fig. 4b durch Weglassen der Kopplung und zusätzliches Vorsehen eines Pneumatikanschlusses 28 unterscheidet. Dieser Kanal 28 ist offen mit der Führungsaufnahme 22" verbunden, so dass dadurch eine Zufuhr von Druckluft in das Volumen der Führungsaufnahme 22" ermöglicht ist. Der Vorsprung 23" trennt das Innere der Führungsaufnahme 22" in zwei Teilbereiche (Kammern). Ein öffnen des Ventils 10'" aus der normalen geschlossenen Position heraus kann somit mittels Erhöhen des Kammerdrucks in der angeschlossenen Kammer erfolgen. Entsprechend kann eine Erhöhung des Anpressdrucks des Dichtmaterials durch Verringerung des Innendrucks unter ein Druckniveau der zweiten Kammer erfolgen.

Fig. 5 zeigt eine Anordnung einer Ventileinheit 10 zusammen mit einer Antriebseinheit 30 als erfindungsgemässes Ventilsystem in einem Elektronenmikroskop 50 zum Schliessen und Öffnen eines Bewegungspfades 51 (Ausbreitungswegs bzw. Führungskanals) für einen Elektronenstrahl.

In einem ersten Bereich 52 des Elektronenmikroskops befindet sich ein Elektronenstrahlgenerator, welcher als Elektronenstrahlquelle für die Untersuchung von dafür bestimmten Proben dient. Der Elektronenstrahl muss hierfür aus der ersten Kammer 52 entlang eines Bewegungspfades 51, insbesondere in einem Führungskanal, in einen zweiten Bereich 53 des Mikroskops 50 geführt und auf die Probe gerichtet werden.

Aufgrund der Messanforderungen für ein Elektronenmikroskop 50 muss die Probe zur Messung in einer Niederdruckumgebung vorliegen. Da jedoch solche Proben regelmässig ausgetauscht werden, ist eine jeweilige Evakuierung des Probenraums 53 notwendig. Um auf eine zusätzliche erneute Evakuierung der Einhausung des Stahlgenerators bzw. des Bewegungspfads des Elektronenstrahls verzichten zu können, ist ein Ventil 10 zwischen diesem Bereich 52 und dem Probenraum 53 zum Verschliessen und Öffnen des Durchtrittsbereichs nach Bedarf vorgesehen. Für den Vorgang des Be- und Entladens (und während anderweitigen Öffnungen) der Probenkammer 53 wird die Elektronenstrahlerzeugungs-Kammer 52 durch Schliessen des Ventils 10 funktional gasdicht abgetrennt. So bleibt in diesem Raum 52 der Vakuum- bzw. Niederdruckzustand erhalten.

Nachdem die Probe eingebracht ist, ein Sperr- bzw. Transferventil 54 zu einer Schleuse 55 geschlossen ist und der Probenraum 53 erneut evakuiert ist, wird dann die Ventileinheit 10 mittels Bewegen des Verschlusselements geöffnet. Das Öffnen erfolgt aufgrund einer durch ein Rückstellelement des Ventils 10 bewirkten Kraft auf das Verschlusselement und einer Bewegung des Kontaktelements 31 in Öffnungsrichtung (orthogonal zur Durchtrittsachse in Richtung der Antriebseinheit). Das Ventil 10 kann somit in geöffneter Position elektrisch und mechanisch entkoppelt von der Antriebseinheit 30 vorliegen (durch Ablösen des Kontaktelements 31 von dem Ventil durch Weiterbewegung nach Erreichen der definierten geöffneten Ventilposition). Eine solch insbesondre elektrische Entkopplung ist hinsichtlich der Genauigkeit, Verlässlichkeit und Robustheit von Messungen mit dem Elektronenmikroskop 50 erforderlich.

Es versteht sich, dass die dargestellten Figuren nur mögliche Ausführungsbeispiele schematisch darstellen. Die verschiedenen Ansätze können erfindungsgemäss ebenso miteinander sowie mit Verfahren und Vorrichtungen zum Verschliessen von Volumina unter Vakuumbedingungen des Stands der Technik kombiniert werden.

## Patentansprüche

1. Vakuumventileinheit (10,10',10" ,10"') zum gasdichten Schliessen eines Bewegungspfades (51) mittels einer Linearbewegung, mit
• einem Ventilgehäuse (11) mit
□ einer Durchtrittsöffnung (13) für den Bewegungspfad (51), wobei die Durchtrittsöffnung (13) eine geometrische Öffnungsachse in Durchtrittsrichtung definiert, und
□ einer die Durchtrittsöffnung (13) umschliessenden, zumindest teilweise gekrümmten Ventilsitzfläche (14),
• einem Verschlusselement (12,12"), das
□ linear entlang einer zu der Öffnungsachse quer verlaufenden, geometrischen Verstellachse in einer Verschlusselementebene von
• einer die Durchtrittsöffnung (13) freigebenden, geöffneten Position in
• eine über die Durchtrittsöffnung (13) linear geschobene, geschlossene Position in eine Schliessrichtung
und umgekehrt zurück in eine Öffnungsrichtung verschiebbar ist, und
□ eine mit der Ventilsitzfläche (14) korrespondierende, eine der Ventilsitzfläche (14) entsprechende Form aufweisende Verschlusselementfläche (15) aufweist,
wobei
• die Flächennormalen der zumindest teilweise gekrümmten Ventilsitzfläche (14) und der Verschlusselementfläche (15) im Wesentlichen parallel zu der Verschlusselementebene verlaufen und
• die Ventilsitzfläche (14) und die Verschlusselementfläche (15) derart ausgebildet sind, dass jeweilige Hauptabschnitte (14a,14b,15a,15b) dieser Flächen (14,15) in jeweils zumindest zwei Ebenen parallel zur Verschlusselementebene vorliegen, **dadurch gekennzeichnet, dass**
die Vakuumventileinheit (10,10',10" ,10"') eine Linearführungseinheit (20) aufweist mit
• einem Führungselement (21,21',21"),
• einer Führungsaufnahme (22,22',22") für das Führungselement (21,21',21") und
• einer Rückstellkomponente (25,25',25"),
wobei
• das Ventilgehäuse (11) mit dem Verschlusselement (12) mittels der Linerführungseinheit (20) derart beweglich verbunden ist, dass dadurch die lineare Verschiebbarkeit entlang der Verstellachse definiert bereitgestellt ist, und
• die Rückstellkomponente (25,25',25") derart mit dem Führungselement (21,21',21") und der Führungsaufnahme (22,22',22") angeordnet ist und zusammenwirkt, dass das Führungselement (21,21',21") und die Führungsaufnahme (22,22',22") mit einer Rückstellkraft parallel zur Verstellachse beaufschlagt sind.

2. Vakuumventileinheit (10,10',10",10"') nach Anspruch 1,
**dadurch gekennzeichnet, dass**
das Führungselement (21,21',21") starr mit dem Verschlusselement (12,12") verbunden ist, insbesondere einen Teil des Verschlusselements (12,12") bildet.

3. Vakuumventileinheit (10,10',10" ,10"') nach Anspruch 1 oder 2,
**dadurch gekennzeichnet, dass**
die Führungsaufnahme (22,22',22") starr mit dem Ventilgehäuse (11) verbunden ist, insbesondere in das Ventilgehäuse (11) integriert ist.

4. Vakuumventileinheit (10,10',10" ,10"') nach einem der Ansprüche 1 bis 3,
**dadurch gekennzeichnet, dass**
das Ventilgehäuse (11) und das Verschlusselement (12,12") mittels der Linerführungseinheit (20) derart beweglich verbundnen sind, dass eine relative Beweglichkeit nur in einem Freiheitsgrad entlang der Verstellachse gegeben ist.

5. Vakuumventileinheit (10,10',10",10"') nach einem der Ansprüche 1 bis 4,
**dadurch gekennzeichnet, dass**
die Linerführungseinheit (20) so ausgestaltet ist, dass eine entsprechend der Verschiebbarkeit des Verschlusselements (12,12") aus der geschlossenen in die geöffnete Position begrenzte Verschiebungsstrecke für die lineare Verschiebbarkeit entlang der Verstellachse definiert ist.

6. Vakuumventileinheit (10,10',10" ,10"') nach Anspruch 5,
**dadurch gekennzeichnet, dass**
die Verschiebungsstrecke durch einen Vorsprung des Führungselements (21,21',21"), welcher mit einer strukturell vorgesehenen Begrenzung der Führungsaufnahme (22,22',22") zusammenwirkt, insbesondere einem Ende der Führungsaufnahme (22,22',22") oder einer Buchse (24), begrenzt ist.

7. Vakuumventileinheit (10,10',10",10"') nach einem der Ansprüche 1 bis 6,
**dadurch gekennzeichnet, dass**
der Bewegungspfad (51) einen Ausbreitungsweg eines Elektronenstrahls eines Elektronenmikroskops (50) verkörpert und die Vakuumventileinheit (10,10',10",10"') zum gasdichten Trennen des Bewegungspfads (51) zu einem Probenraum (53) ausgebildet ist.

8. Vakuumventileinheit (10,10',10",10"') nach einem der Ansprüche 1 bis 7,
**dadurch gekennzeichnet, dass**
die Rückstellkraft derart in die Öffnungsrichtung wirkt, dass das Verschlusselement (12,12") in einem Normalzustand in einer der geöffneten Position entsprechenden Normalposition vorliegt, insbesondere wobei die Rückstellkomponente (25,25',25") eine Feder (25) oder Zugfeder (25') ist.

9. Vakuumventileinheit (10,10',10",10"') nach einem der Ansprüche 1 bis 8,
**dadurch gekennzeichnet, dass**
die Linearführungseinheit (20), insbesondere die Führungsaufnahme (22,22',22"), partikeldicht ausgebildet ist, insbesondere wobei das Führungselement (21,21',21") aus abriebsarmem, insbesondere abriebsfreiem, Material gefertigt ist.

10. Vakuumventileinheit (10,10',10" ,10"') nach einem der Ansprüche 1 bis 9,
**dadurch gekennzeichnet, dass**
die Vakuumventileinheit (10,10',10",10"') eine lösbare Arretiervorrichtung aufweist, welche
• ein Halten des Verschlusselements (12,12") in der geöffneten und/oder geschlossenen Position und
• ein jeweiliges Lösen des Haltens
nach Bedarf bereitstellt.

11. Vakuumventileinheit (10,10',10",10"') nach einem der Ansprüche 1 bis 10,
**dadurch gekennzeichnet, dass**
• die Ventilsitzfläche (14) unterschiedlich geformte, jeweils zu der Verstellachse nichtparallele Abschnitte aufweist,
• die Flächennormalen der Abschnitte der Ventilsitzfläche (14) zu der Verstellachse jeweils parallele Richtungskomponenten aufweisen,
• ein erster Hauptabschnitt (14a) der Ventilsitzfläche (14) im Wesentlichen entlang einer geometrischen ersten Hauptebene verläuft,
• ein zweiter Hauptabschnitt (14b) der Ventilsitzfläche (14) im Wesentlichen entlang einer geometrischen zweiten Hauptebene verläuft,
• die erste Hauptebene und die zweite Hauptebene zueinander beabstandet sind und parallel zu der Verschlusselementebene verlaufen,
• der erste Hauptabschnitt (14a) und der gegenüberliegende zweite Hauptabschnitt (14b) zueinander einen geometrischen Versatz quer zu der Verstellachse aufweisen,
• zwischen den beiden gegenüberliegenden Hauptabschnitten (14a,14b) die Durchtrittsöffnung (13) angeordnet ist,
• ein seitlicher erster U-förmiger Seitenabschnitt der Ventilsitzfläche den ersten Hauptabschnitt (14a) und den zweiten Hauptabschnitt (14b) auf der einen Seite der Ventilsitzfläche (14) verbindet,
• ein seitlicher zweiter U-förmiger der Ventilsitzfläche (14) den ersten Hauptabschnitt (14a) und den zweiten Hauptabschnitt (14b) auf der anderen Seite der Ventilsitzfläche (14) verbindet,
• der erste U-förmige Seitenabschnitt und der zweite U-förmige Seitenabschnitt jeweils einen dem ersten Hauptabschnitt (14a) zugeordneten ersten Schenkel, einen dem zweiten Hauptabschnitt (14b) zugeordneten zweiten Schenkel und eine Basis, die insbesondere als Bogen ausgebildet ist, aufweist,
• die beiden ersten Schenkel jeweils im Wesentlichen entlang zu der Verstellachse parallelen ersten Schenkelebenen verlaufen,
• der erste Schenkel und der zweite Schenkel zueinander einen geometrischen Versatz quer zu der Verstellachse aufweisen,
• die jeweilige Basis jeweils den ersten Schenkel und den zweiten Schenkel verbindet und den geometrischen Versatz quer zu der Verstellachse überbrückt, und
• die Verschlusselementfläche (15) in der geschlossenen Position in einem auf die Ventilsitzfläche (14) in die Schliessrichtung drückenden - vermittels eines Dichtmaterials (16) - dichtenden Kontakt mit der Ventilsitzfläche (14) steht und dadurch die Durchtrittsöffnung (13) gasdicht verschlossen ist.

12. Vakuumventilsystem aus
• einer Vakuumventileinheit (10,10',10" ,10"') nach einem der Ansprüche 1 bis 11 und
• einer Antriebseinheit (30),
wobei die Vakuumventileinheit (10,10',10",10"') und die Antriebseinheit (30) derart angeordnet sind und zusammenwirken, dass das Verschlusselement (12,12") mittels der Antriebseinheit (30) entlang der Verstellachse verschiebbar ist,
**dadurch gekennzeichnet, dass**
• zum Verschieben des Verschlusselements (12,12") eine der Rückstellkraft entgegenwirkende Antriebskraft mittels der Antriebseinheit (30) bereitstellbar ist,
• die Antriebseinheit (30) ein entlang einer Bewegungsachse zumindest im Wesentlichen parallel zur Verstellachse bewegbares Kontaktelement (31) zur Kontaktierung des Verschlusselements (12,12") für das Verschieben aufweist und
• die Antriebseinheit (30) derart ausgebildet und angeordnet ist, dass das Kontaktelement (31) entlang der Bewegungsachse
□ in Kontakt mit dem Verschlusselement (12,12") und
□ kontaktlos mit dem Verschlusselement (12,12") bewegbar und positionierbar ist,
sodass bei Vorliegen von Kontaktlosigkeit die Antriebseinheit (30) elektrisch und mechanisch von der Vakuumventileinheit (10,10',10",10"') getrennt ist.

13. Vakuumventilsystem nach Anspruch 12,
**dadurch gekennzeichnet, dass**
die Antriebseinheit (30) eine Bewegungsstrecke für das Kontaktelement (31) entlang der Bewegungsachse bereitstellt, die grösser ist als die der Verschiebung des Verschlusselements (12,12") aus der geschlossenen in die geöffnete Position entsprechenden Verschiebungsstrecke.

14. Vakuumventilsystem nach Anspruch 12 oder 13,
**dadurch gekennzeichnet, dass**
die Vakuumventileinheit (10,10',10" ,10"') und die Antriebseinheit (30) derart zusammenwirken, dass
• das Verschlusselement (12,12") linear entlang der Verstellachse
□ von der geschlossenen Position, in welcher die gegen die Rückstellkraft wirkende Kraft mittels der Antriebseinheit (30) bei Kontakt des Kontaktelements (31) mit dem Verschlusselement (12,12")) bereitgestellt ist,
□ in die geöffnete Position durch
• ein Bewegen des Kontaktelements (31) entlang der Bewegungsachse zumindest im Wesentlichen in Öffnungsrichtung und
• gleichzeitiges Wirken der Rückstellkraft verschiebbar ist, und
• eine elektrische Isolation der Antriebseinheit (30) von der Vakuumventileinheit (10,10',10",10"') durch ein Weiterbewegen des Kontaktelements (31) entlang der Bewegungsachse zumindest im Wesentlichen in Öffnungsrichtung nach Erreichen der geöffneten Position herstellbar ist, wobei ein physischer Kontakt des Kontaktelements (31) mit dem Verschlusselement (12,12") unterbrochen wird.
